# EUROPEAN PATENT APPLICATION

(11) **EP 4 827 247 A1**
(43) Date of publication of application: **21.10.2026**
(21) Application number: 24904305.0
(22) Date of filing: 16.12.2024
(51) Int. Cl.: H05K 1/02, H05K 3/28, H05K 1/14, H05K 1/18, H05K 1/11

(54) **FLEXIBLE CIRCUIT BOARD, COF MODULE AND ELECTRONIC DEVICE COMPRISING SAME**

(30) Priority: 14.12.2023 KR 20230181877
(71) Applicant: LG Innotek Co., Ltd., Seoul 07796 (KR)
(72) Inventor: YOON, Hyung Kyu, Seoul 07796 (KR); CHAE, Sung Min, Seoul 07796 (KR); PARK, Ji Hyo, Seoul 07796 (KR)
(74) Representative: DREISS Patentanwälte PartG mbB
(86) International application number: PCT/KR2024/020364
(87) International publication number: WO 2025/127740

(57) **Abstract**

A flexible circuit board according to an embodiment comprises a substrate; a plurality of circuit patterns disposed on the substrate; and a protective layer disposed on the circuit patterns, wherein a thickness of each of the plurality of circuit patterns exceeds 8 um and is less than or equal to 25 um, and wherein a thickness deviation between the plurality of circuit patterns is 0.5 um to 3 um.

## Description

### Technical Field

An embodiment relates to a flexible circuit board, a COF module and an electronic device including the same.

### Background Art

Recently, various electronic products are becoming thinner and smaller. Accordingly, it is required to mount semiconductor chips in a narrow region of the electronic product at a high density.

A COF (Chip On Film) includes a circuit board and a chip disposed on the circuit board. The circuit board is flexible. That is, the COF is a flexible circuit board. Accordingly, the COF is applied to a flexible display. For example, the COF can be applied to various wearable electronic devices. In addition, the COF has a fine pitch. Accordingly, the COF is applied to a display having a high resolution.

The chip includes a semiconductor chip. For example, the chip can be an integrated circuit (IC) chip or a large scale integrated circuit (LSI) chip.

The chip is connected to an external circuit board and a display panel through a circuit pattern. For example, pad portions are provided at each one end and other end of the circuit pattern. Either pad portion is electrically connected to a terminal of the chip. Another pad portion is connected to terminals of the external circuit board and the display panel. Accordingly, the chip, the external circuit board, and the display panel are electrically connected through the COF. Accordingly, a signal is transmitted to the display panel through the circuit pattern.

As a performance of the display panel increases, a current amount of the display panel increases. Accordingly, the flexible circuit board is connected to the display panel. Accordingly, the circuit pattern may be damaged by a high current. As a result, the reliability of the COF module may decrease.

Therefore, a new structure of a flexible circuit board, a COF module, and an electronic device including the same that can solve the above problems are required.

As a patent related to the flexible circuit board, Korean Patent Registration No. KR10-0618898 (2006.09.01) is disclosed.

### Disclosure

### Technical Problem

The embodiment provides a flexible circuit board having improved reliability and a COF module including the same.

### Technical Solution

A flexible circuit board according to an embodiment comprises a substrate; a plurality of circuit patterns disposed on the substrate; and a protective layer disposed on the circuit patterns, wherein a thickness of each of the plurality of circuit patterns exceeds 8 um and is less than or equal to 25 um, and wherein a thickness deviation between the plurality of circuit patterns is 0.5 um to 3 um.

In addition, each of the plurality of circuit patterns includes a buffer layer disposed on the substrate, a metal layer disposed on the buffer layer, and a bonding layer disposed on the metal layer.

In addition, the bonding layer is disposed to cover a side surface of the buffer layer, a side surface of the metal layer, and an upper surface of the metal layer.

In addition, a thickness deviation between the metal layers of the plurality of circuit patterns is 0.5 um to 3 um.

In addition, the metal layer includes a first metal layer and a second metal layer on the first metal layer, and wherein a thickness of the second metal layer is greater than a thickness of the first metal layer.

In addition, a thickness deviation between the second metal layers of the plurality of circuit patterns is 0.5 um to 3 um.

In addition, the substrate includes a first side end and a second side end, the protective layer includes a first open region overlapping a region between the first side end and the second side end along a thickness direction, a second open region spaced apart from the first open region and most adjacent to the first side end, and a third open region spaced apart from the first open region and the second open region and most adjacent to the second side end.

In addition, the plurality of the circuit pattern includes: a first circuit pattern including a first pad part disposed in the first open region, a second pad part disposed in the second open region, and a first wiring part connecting the first pad part and the second pad part; and a second circuit pattern including a third pad part disposed in the first open region; a fourth pad part disposed in the third open region, and a second wiring part connecting the third pad part and the fourth pad part.

In addition, a thickness deviation of the first circuit pattern is 0.3 um to 2.5 um.

In addition, a thickness deviation of the second circuit pattern is 0.3 um to 5 um.

In addition, a thickness deviation of each the first pad part and the third pad part is 0.3 um to 0.9 um.

In addition, a thickness deviation of the second pad part is 0.5 um to 3 um.

In addition, a thickness deviation of the fourth pad part is 1 um to 5 um.

In addition, the plurality of circuit patterns further includes a third circuit pattern including a fifth pad part disposed in the second open region, a sixth pad part disposed in the third open region; and a third wiring part connecting the fifth pad part and the sixth pad part.

In addition, a thickness deviation between the first circuit pattern, the second circuit pattern, and the third circuit pattern is 1 um to 5 um.

In addition, the first circuit pattern is disposed on one surface of the substrate, the third circuit pattern is disposed on an other surface of the substrate, and the second circuit pattern is disposed on the one surface and the other surface of the substrate, respectively, and is connected through a via.

### Advantageous Effects

A flexible circuit board according to an embodiment includes a plurality of circuit patterns. The circuit patterns have a set thickness. In detail, the circuit patterns have a thickness exceeding 8µm. In addition, the circuit patterns have a uniform line width.

The flexible circuit board is connected to a display panel. The display panel can have high performance. Accordingly, a high current can flow through the display panel.

The high current is transmitted to the flexible circuit board. Since the circuit patterns are formed within a set thickness range, the circuit patterns can be prevented from being damaged by the high current.

The circuit patterns have a uniform thickness. That is, a thickness deviation of the circuit patterns is small.

In detail, a plating process for forming the circuit patterns is controlled. In detail, during the plating process, a shielding layer can be disposed in a region where the plating thickness is thick to control a plating thickness of other regions to have a uniform thickness.

Therefore, a thickness deviation between the circuit patterns is reduced. In addition, a thickness deviation of each the circuit patterns is reduced. In addition, a thickness deviation of each pad part is reduced.

Therefore, the signal or current moving in each circuit pattern becomes uniform. Therefore, the electrical characteristics of the flexible circuit board and COF module are improved.

### Description of Drawings

FIG. 1 is a top view of a flexible circuit board according to an embodiment.
FIG. 2 and FIG. 3 are cross-sectional views taken along a region A-A' of FIG. 1.
FIG. 4 is a cross-sectional view taken along a region B-B' of FIG. 1.
FIG. 5 and FIG. 6 are views illustrating a first process for forming a circuit pattern.
FIG. 7 is a scanning electron microscope (SEM) image of a circuit pattern formed by a first process.
FIGS. 8 to 16 are views illustrating a second process for forming a circuit pattern.
FIG. 17 is a scanning electron microscope (SEM) image of a circuit pattern formed by a second process.
FIG. 18 is a view for explaining a connection between a COF module and other members according to an embodiment.
FIGS. 19 to 21 are views illustrating an electronic device including a flexible circuit board according to an embodiment

### Modes of the Invention

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", or "coupled" to another element, it may include not only when the element is directly "connected" to, or "coupled" to other elements, but also when the element is "connected", or "coupled" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

In the following description, a first direction 1D is a direction in which a pad part of the display panel and a pad part of the circuit board face each other. In addition, a second direction 2D is a direction perpendicular to the first direction 1D.

Hereinafter, a flexible circuit board and a COF module including the same according to an embodiment will be described with reference to the drawings.

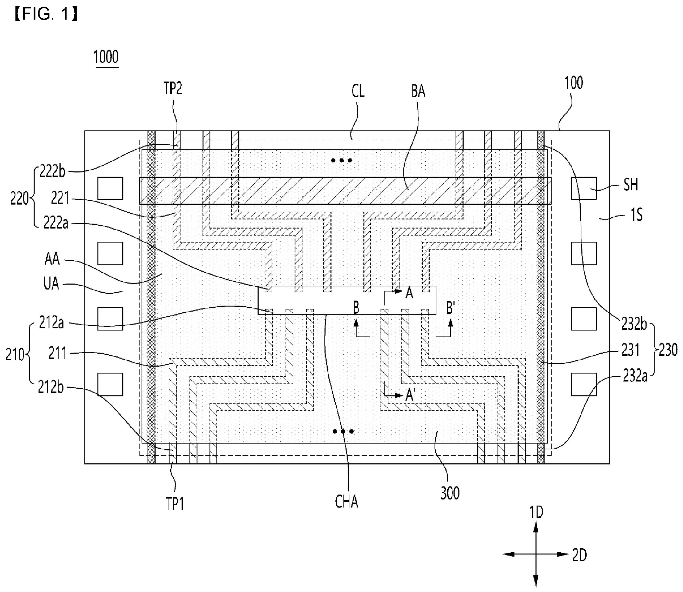

Referring to FIG. 1, a flexible circuit board 1000 according to an embodiment includes a substrate 100, a circuit pattern, and a protective layer 300.

The substrate 100 includes a first surface 1S and a second surface 2S opposite to the first surface 1S. The circuit pattern and the protective layer 300 are disposed on the first surface 1S.

The substrate 100 includes a cutting line CL. The flexible circuit board 1000 is cut along the cutting line CL. For example, a circuit pattern, a metal pattern, a protective layer, and a chip are disposed on the substrate 100. Thereafter, the substrate 100 is cut along the cutting line CL. Accordingly, the COF module is manufactured. Therefore, an edge of the COF module becomes the cutting line CL.

The substrate 100 includes an effective region AA and an ineffective region UA. In detail, the first surface 1S includes the effective region AA and the ineffective region UA.

The effective region AA and the ineffective region UA are separated by the cutting line CL. The effective region AA is an inner region of the cutting line CL. In addition, the ineffective region UA is an outer region of the cutting line CL.

The circuit pattern, the protective layer, and the chip are disposed on the effective region AA. In addition, a dummy pattern and a sprocket hole SH are disposed on the ineffective region UA. The dummy pattern increases a strength of the substrate 100. In addition, the flexible circuit board 1000 is rolled or unrolled in a roll-to-roll manner by the sprocket hole SH.

The substrate 100 includes a chip mounting region CHA. The chip mounting region CHA is disposed on the first surface 1S. The chip mounting region CHA is disposed on the effective region AA. The chip CH is disposed on the chip mounting region CHA. In addition, pad parts of the circuit pattern are disposed inside the chip mounting region CHA. In addition, the protective layer 300 is not disposed on the chip mounting region CHA.

The substrate 100 includes a flexible material. For example, the substrate 100 may include polyimide (PI). However, the embodiment is not limited thereto. The substrate 100 may include a polymer material including polyethylene terephthalate (PET) or polyethylene naphthalate (PEN). Accordingly, the flexible circuit board may be applied to various electronic devices including a curved display device.

The substrate 100 may have a thickness of 20 µm to 100 µm. For example, the substrate 100 may have a thickness of 25 µm to 50 µm. For example, the substrate 100 may have a thickness of 30 µm to 40 µm. If the thickness of the substrate 100 exceeds 100 µm, an overall thickness of the flexible circuit board increases. As a result, the flexible characteristic of the flexible circuit board may be reduced. In addition, if the thickness of the substrate 100 is less than 20um, the substrate 100 may be damaged by heat and pressure applied to the substrate when the chip is mounted on the flexible circuit board.

The circuit pattern and the protective layer 300 are disposed on the substrate 100. In detail, the circuit pattern and the protective layer 300 are disposed on the first surface 1S. In detail, the circuit pattern and the protective layer 300 are disposed on at least one region among the effective region AA and the ineffective region UA.

The circuit pattern includes a first circuit pattern 210, a second circuit pattern 220, and a third circuit pattern 230.

Referring to FIG. 1, the first circuit pattern 210 includes a first wiring part 211, a first pad part 212a, and a second pad part 212b. The first wiring part 211, the first pad part 212a, and the second pad part 212b may include a same material. In addition, the first wiring part 211, the first pad part 212a, and the second pad part 212b may be formed integrally.

The first pad part 212a is disposed inside the chip mounting region CHA. Accordingly, the first pad part 212a is connected to a terminal of the chip. Accordingly, the first circuit pattern 210 and the chip are connected.

The second pad part 212b is disposed outside the chip mounting region CHA. The second pad part 212b is connected to a pad part of the circuit board 3000. Accordingly, the first circuit pattern 210 and the circuit board 3000 are connected.

The first wiring part 211 is disposed between the first pad part 212a and the second pad part 212b. The first wiring part 211 connects the first pad part 212a and the second pad part 212b. Accordingly, the chip CH and the circuit board 3000 are connected. Accordingly, a signal generated from the chip CH is transmitted to the circuit board 3000.

The first circuit pattern 210 may further include a test pad part. In detail, a first test pad part TP1 is disposed in the ineffective region UA. The first wiring part 211, the first pad part 212a, the second pad part 212b, and the first test pad part TP1 may be formed integrally.

Before connecting the circuit board and the second pad part 212b, the first circuit pattern 210 can be tested by the first test pad part TP1. For example, the first test pad part TP1 can be used to check whether the first circuit pattern is open or shorted.

The second circuit pattern 220 includes a second wiring part 221, a third pad part 222a, and a fourth pad part 222b. The second wiring part 221, the third pad part 222a, and the fourth pad part 222b can include a same material. In addition, the second wiring part 221, the third pad part 222a, and the fourth pad part 222b can be formed integrally.

The third pad part 222a is disposed inside the chip mounting region CHA. Accordingly, the third pad part 222a is connected to a terminal of the chip. Accordingly, the second circuit pattern 220 and the chip CH are connected.

The fourth pad part 222b is disposed outside the chip mounting region CHA. The fourth pad part 222b is connected to a pad part of an external display panel 4000. Accordingly, the second circuit pattern 220 and the display panel 4000 are connected.

The second wiring part 221 is disposed between the third pad part 222a and the fourth pad part 222b. The second wiring part 221 connects the third pad part 222a and the fourth pad part 222b. Accordingly, the chip CH and the display panel 4000 are connected. Accordingly, the signal generated from the chip CH is transmitted to the display panel 4000.

The second circuit pattern 220 may further include a test pad part. In detail, a second test pad part TP2 is disposed in the ineffective region UA. The second test pad part TP2 is disposed outside the cutting line CL. The second test pad part TP2 is disposed on the ineffective region UA. The second wiring part 221, the third pad part 222a, the fourth pad part 222b, and the second test pad part TP2 may be formed integrally.

Before connecting the circuit board and the fourth pad part 222b, the second circuit pattern 220 may be tested by the second test pad part TP2. For example, the second test pad part TP2 can be used to check whether the second circuit pattern is open or shorted.

The third circuit pattern 230 includes a third wiring part 231, a fifth pad part 232a, and a sixth pad part 232b. The third wiring part 231, the fifth pad part 232a, and the sixth pad part 232b may include a same material. In addition, the third wiring part 231, the fifth pad part 232a, and the sixth pad part 232b may be formed integrally.

The fifth pad part 232a and the sixth pad part 232b are disposed outside the chip mounting region CHA. The fifth pad part 232a may be connected to a pad part of the circuit board TP2. In addition, the sixth pad part 232b may be connected to the pad part of the display panel 4000.

The third wiring part 231 is disposed between the fifth pad part 232a and the sixth pad part 232b. The third wiring part 231 connects the fifth pad part 232a and the sixth pad part 232b. Accordingly, the circuit board 3000 and the display panel 4000 are connected.

The third circuit pattern 230 may be a bypass circuit. For example, the third circuit pattern 230 may be a power supply pattern. Accordingly, the circuit board and the display panel may be supplied with power by the third circuit pattern 230.

The third circuit pattern 230 may include a plurality of third circuit patterns spaced apart in the second direction 2D. A line width and a spacing of the third circuit pattern 230 may be larger than a line width and a spacing of the first circuit pattern 210. In addition, a line width and a spacing of the third circuit pattern 230 may be larger than the line width and spacing of the second circuit pattern 220.

Although not shown in the drawing, at least one dummy pattern may be disposed on the effective region AA.

The dummy pattern may prevent the flexible circuit board 1000 from being bent. In addition, the spacing and line width of the circuit pattern may be made uniform by the dummy pattern.

The dummy pattern may include the same material as the circuit pattern. A line width of the dummy pattern may be the same as or different from that of the circuit pattern. The dummy pattern is not connected to the chip CH, the circuit board 3000, and the display panel 4000.

At least one of the third circuit pattern and the dummy pattern may be an outermost pattern. In detail, the outermost pattern of the second direction 2D of the substrate 100 may be at least one of the third circuit pattern and the dummy pattern.

The protective layer 300 is disposed on the first surface 1S. Accordingly, the protective layer 300 is disposed on the first circuit pattern 210, the second circuit pattern 220, and the third circuit pattern 230. The protective layer 300 is disposed on the first wiring part 211, the second wiring part 221, and the third wiring part 231. The protective layer 300 is not disposed on the first pad part 212a, the second pad part 212b, the third pad part 222a, the fourth pad part 222b, the fifth pad part 232a, and the sixth pad part 232b. In addition, the protective layer 300 is not disposed on the chip mounting region CHA.

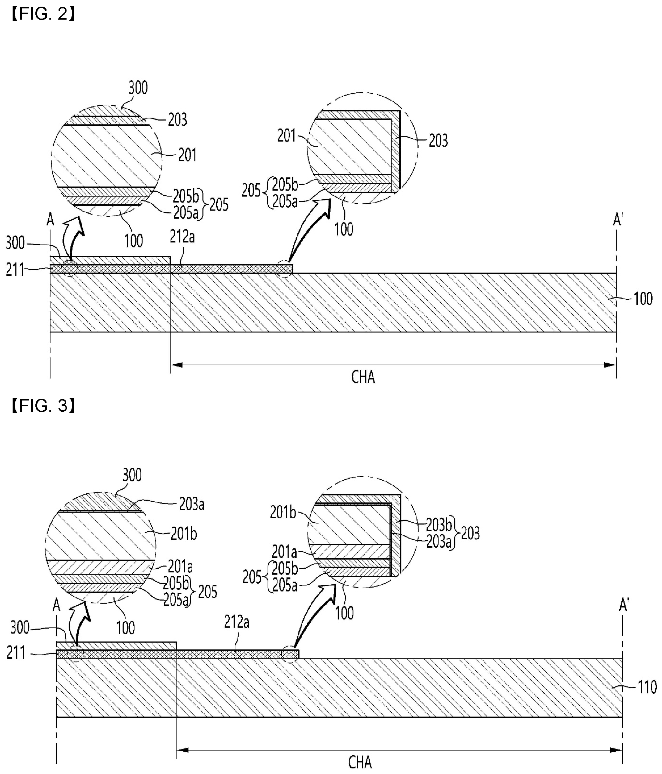

Referring to FIGS. 2 and 3, the circuit pattern is formed in a multilayer structure. FIGS. 2 and 3 are described based on the first circuit pattern. The following description is equally applied to the second and third circuit patterns.

Referring to FIG. 2, the first circuit pattern is formed in a multilayer structure. In detail, the first wiring part 211, the first pad part 212a, and the second pad part 212b include a buffer layer 205, a metal layer 201, and a bonding layer 203.

The buffer layer 205 may include a multilayer structure. In detail, the buffer layer 205 includes a first buffer layer 205a and a second buffer layer 205b. The first buffer layer 205a is disposed on the substrate 100. The second buffer layer 205b is disposed on the first buffer layer 205a.

The first buffer layer 205a includes a material having good adhesion to the substrate 100. For example, the first buffer layer 205a may include nickel (Ni). In addition, the second buffer layer 205b includes a material having good adhesion to the circuit pattern. For example, the second buffer layer 205b may include chromium (Cr).

The buffer layer 205 may have a thin film thickness in nanometer units. For example, the buffer layer 205 may have a thickness of 20 nm or less.

The adhesion between the substrate 100 and the circuit pattern is improved by the buffer layer 205.

The metal layer 201 is disposed on the buffer layer 205. In detail, the metal layer 201 is disposed on the second buffer layer 205b. The metal layer 201 includes a metal material. For example, the metal layer 201 may include copper (Cu).

The metal layer 201 may be formed by electroplating using the buffer layer as a seed layer. That is, the metal layer 201 may be a plating layer.

A thickness of the metal layer 201 may be 10 um to 30 um.

The bonding layer 203 is disposed on the metal layer 201.

The bonding layer 203 is disposed on a side surface and an upper surface of the metal layer 201. For example, the bonding layer 203 may be disposed while surrounding the metal layer 201.

The bonding layer 203 includes a metal. For example, the bonding layer 203 may include tin (Sn). The bonding layer 203 is formed by a plating process. In detail, the bonding layer 203 may be a plating layer.

A thickness of the bonding layer 203 may be 0.3 um to 0.7 um. A tin content may increase as it extends from a lower surface of the bonding layer 203 toward an upper surface of the bonding layer 203.

That is, the bonding layer 203 is in contact with the metal layer 201. Therefore, the tin content increases as it extends from the lower surface of the bonding layer 203 toward the upper surface of the bonding layer 203. In addition, a copper content decreases as it extends from the lower surface of the bonding layer 203 toward the upper surface of the bonding layer 203.

Accordingly, pure tin may remain in a thickness range of 0.1 um to 0.3 um from the upper surface of the bonding layer 203.

The pad part can be easily bonded to the terminals of the chip, the circuit board, and the display panel by the bonding layer 203. For example, when heat and pressure are applied to the pad part, an upper surface of the bonding layer melts. Pure tin remains on the upper surface of the bonding layer. Therefore, the pad part can be easily bonded to the terminals of the chip, the circuit board, and the display panel.

Referring to FIG. 3, the metal layer 201 layer may include a first metal layer 201a and a second metal layer 201b. The first metal layer 201a is disposed on the buffer layer 205. The second metal layer 201b is disposed on the first metal layer 201a. The second metal layer 201b may be formed by electroplating using the first metal layer 201a as a seed layer. That is, the second metal layer 201b may be a plating layer.

A thickness of the first metal layer 201a may be smaller than a thickness of the second metal layer 201b.

For example, the thickness of the first metal layer 201a may be 0.7 um to 2 um, and the thickness of the second metal layer 201b may be 6 um to 25 um.

The first metal layer 201a and the second metal layer 201b may include a same metal material. For example, the first metal layer 201a and the second metal layer 201b may include copper (Cu).

The bonding layer 203 may include a first bonding layer 203a and a second bonding layer 203b.

The first bonding layer 203a is disposed on the metal layer 201. In detail, the first bonding layer 203a is disposed on the second wiring part 221, the third pad part 222a, and the fourth pad part 222b.

The second bonding layer 203b is disposed on the first bonding layer 203a. In detail, the second bonding layer 203b is disposed on the third pad part 222a and the fourth pad part 222b.

Therefore, the second wiring part 221 includes the buffer layer 205, the metal layer 201, and the first bonding layer 203a. In addition, the third pad part 222a and the fourth pad part 222b include the buffer layer 205, the metal layer 201, the first bonding layer 203a, and the second bonding layer 203b.

Therefore, a layer structure of the second wiring part 221 is different from layer structures of the first pad part 212a and the second pad part 212b.

The first bonding layer 203a and the second bonding layer 203b include a metal. In detail, the first bonding layer 203a and the second bonding layer 203b may include tin (Sn).

The first bonding layer 203a and the second bonding layer 203b are disposed with different thicknesses. In detail, a thickness of the second bonding layer 203b is greater than a thickness of the first bonding layer 203a.

For example, the first bonding layer 203a has a thickness of 0.02 µm to 0.06 µm. In addition, the second bonding layer 203b has a thickness of 0.2 µm to 0.6 µm.

Accordingly, the thickness of the first wiring part 211 is reduced. The flexible circuit board includes a bending region BA that is bent in one region. The wiring part is disposed on the bending region BA. Therefore, the bonding layer is formed with a small thickness on the wiring part. Accordingly, when the flexible circuit board is bent, it can prevent cracks from occurring in the first wiring part 211.

The thickness of the circuit pattern may be greater than 8 um and less than or equal to 25 um. In detail, the thickness of the circuit pattern may be 9 um to 20 um. In detail, the thickness of the circuit pattern may be 10 um to 15 um.

If the thickness of the circuit pattern is less than 8 um, the resistance of the circuit pattern may increase. In addition, when a high current flows through the display panel, the circuit pattern may be damaged. If the thickness of the circuit pattern exceeds 25 um, it becomes difficult to implement a fine pattern.

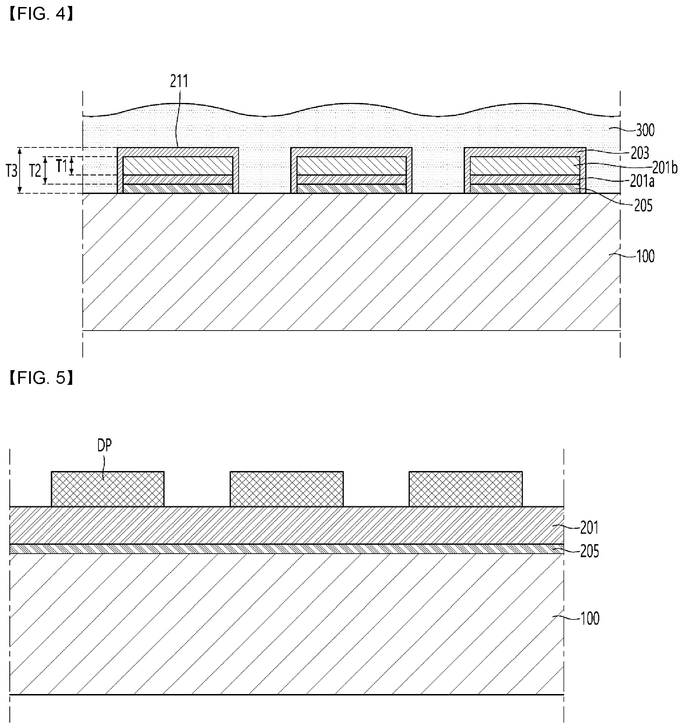

FIG. 4 is a cross-sectional view taken along a region B-B' of FIG. 1.

The first wiring part 211 includes a buffer layer 205, a first metal layer 201a, a second metal layer 201b, and a bonding layer 203. The buffer layer 205 and the bonding layer 203 are formed with a thin film thickness. Accordingly, a total thickness T3 of the first wiring part 211 is determined by a thickness T2 of the metal layer (201a, 201b) or a thickness T2 of the second metal layer 201b.

The metal layer may be formed as one metal layer as in FIG. 2. Alternatively, the metal layer may be formed as two metal layers as in FIG. 3.

FIGS. 5 to 7 are views for explaining a first process of forming a circuit pattern. The first process is a process of forming a circuit pattern as in FIG. 2 with one metal layer.

Referring to FIG. 5, a buffer layer 205 is disposed on the substrate 100. The metal layer 201 is disposed on the buffer layer 205.

Subsequently, a photosensitive layer 400 is disposed on the metal layer 201. The photosensitive layer 400 forms a plurality of photosensitive patterns DP through exposure and development processes. The photosensitive patterns DP are disposed on a region where the circuit pattern is formed. Accordingly, a region between the photosensitive patterns DP becomes an etching region.

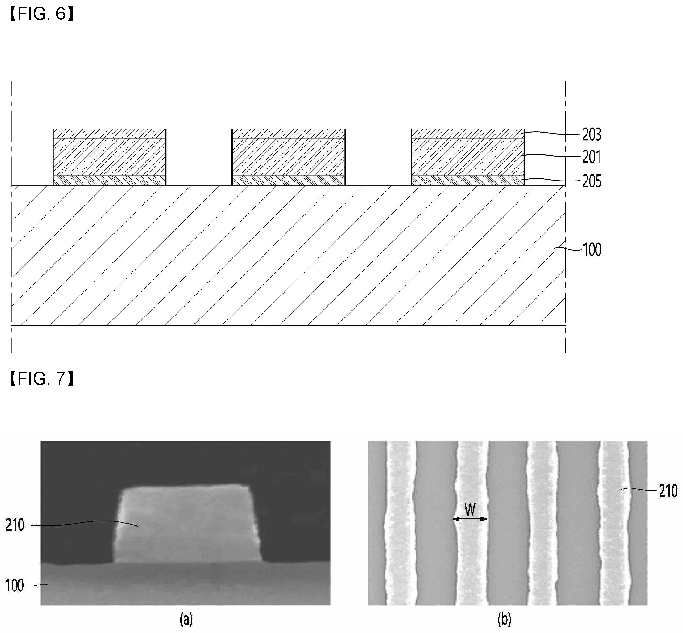

Referring to FIG. 6, the etching region is etched. For example, an etching solution is sprayed onto the etching region to etch the etching region.

After etching the etching region, a bonding layer 205 is formed on the metal layer 201 to form a circuit pattern.

However, if the thickness of the metal layer 201 becomes thicker, the etching uniformity of the circuit pattern may decrease. For example, if the thickness of the metal layer 201 exceeds 8 um, the uniformity of the line width of the circuit pattern may decrease. That is, the thickness of the metal layer 201 is uniform, but the line width may be uneven.

Referring to FIG. 7, it can be seen that the line width W of the circuit pattern 210 is uneven. That is, as shown in (a) of FIG. 7, a line width of the circuit pattern 210 increases as the circuit pattern 210 gets closer to the substrate 100. Accordingly, line widths of the upper and lower surfaces of the circuit pattern 210 become different. As the thickness of the circuit pattern 210 becomes thicker, a line width difference between the upper and lower surfaces of the circuit pattern increases. Therefore, a line width W of the circuit pattern 210 becomes uneven at each location. Therefore, it becomes difficult to form a circuit pattern with a fine line width.

Therefore, the embodiment forms a circuit pattern by a second process different from the first process.

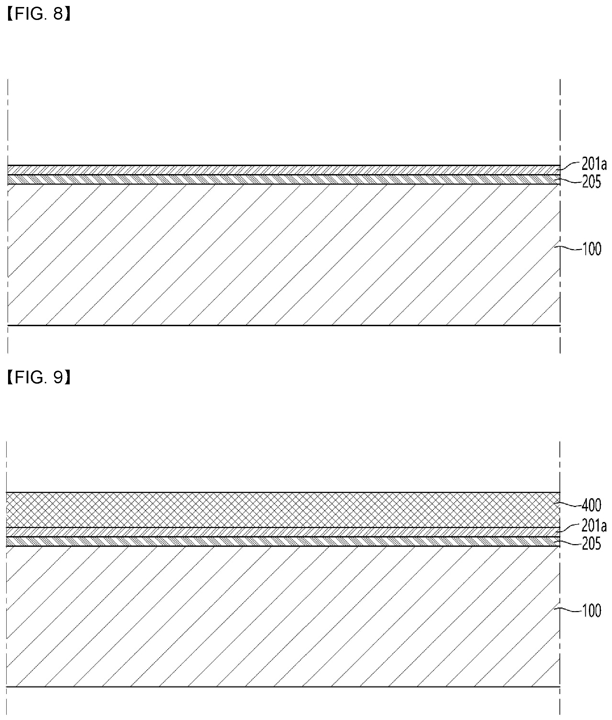

FIGS. 8 to 17 are views illustrating a second process.

Referring to FIG. 8, the buffer layer 205 is disposed on the substrate 100. The first metal layer 201a is disposed on the buffer layer 205. The first metal layer 201a may be formed by electrolytic or electroless plating.

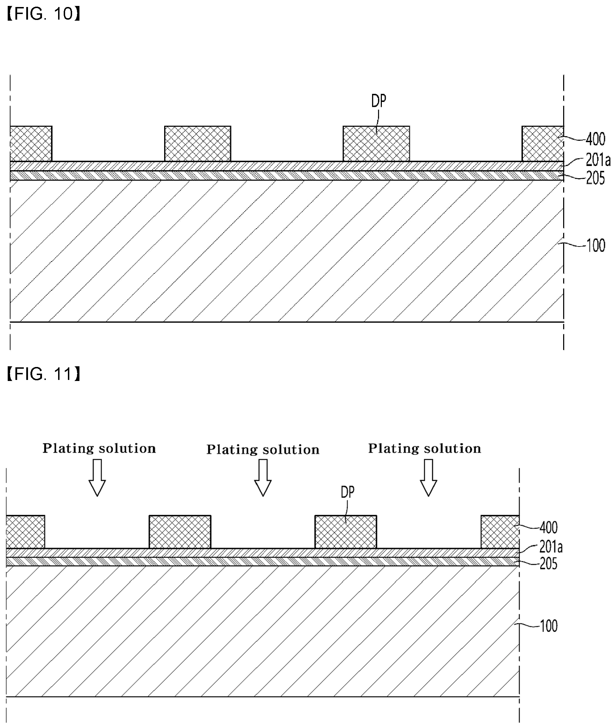

Referring to FIGS. 9 and 10, the photosensitive layer 400 is disposed on the first metal layer 201a. The photosensitive layer 400 forms a plurality of photosensitive patterns DP by exposure and development processes. The photosensitive patterns DP are disposed on a region where the circuit pattern is not formed. Accordingly, the circuit pattern is formed on a region between the photosensitive patterns DP. Accordingly, the region between the photosensitive patterns DP becomes a plating region. Accordingly, a plurality of plating regions are formed.

Referring to FIGS. 11 to 14, a second metal layer 201b is plated on the plating region. For example, a plating solution is sprayed onto the plating region. As a thickness of the second metal layer 201b increases, plating thicknesses of the plating regions may vary. Accordingly, a thickness deviation of the plurality of circuit patterns may increase.

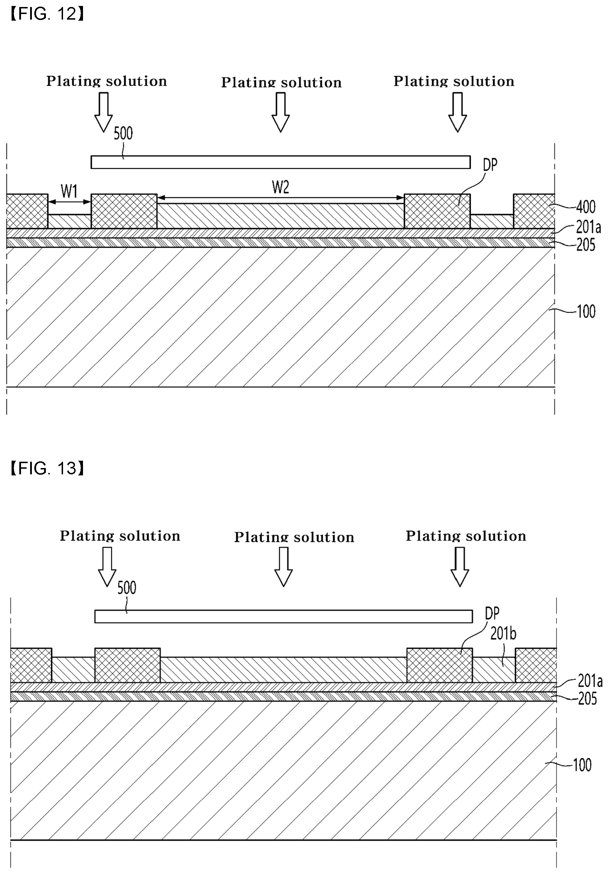

For example, as shown in FIG. 12, a thickness of one plating layer may be greater than a thickness of a plating layer of another region. Accordingly, a shielding layer 500 may be disposed on a plating region having a large plating layer thickness. The plating layer may have a large thickness in a wide region W2. Accordingly, a shielding layer 500 may be formed on a plating region having a large plating layer thickness. The plating is not performed on a plating region overlapping with the shielding layer 500. In addition, the plating is performed on the plating region that does not overlap with the shielding layer 500. Therefore, it is possible to uniformly control a plating thickness of a region in which a thickness of the plating layer is large and a region in which a thickness of the plating layer is small.

As shown in FIG. 13, the shielding layer 500 is disposed until the thickness of the plating layer of the plurality of plating regions becomes uniform. When the thickness of the plating layer of the plurality of plating regions becomes uniform, the shielding layer is removed.

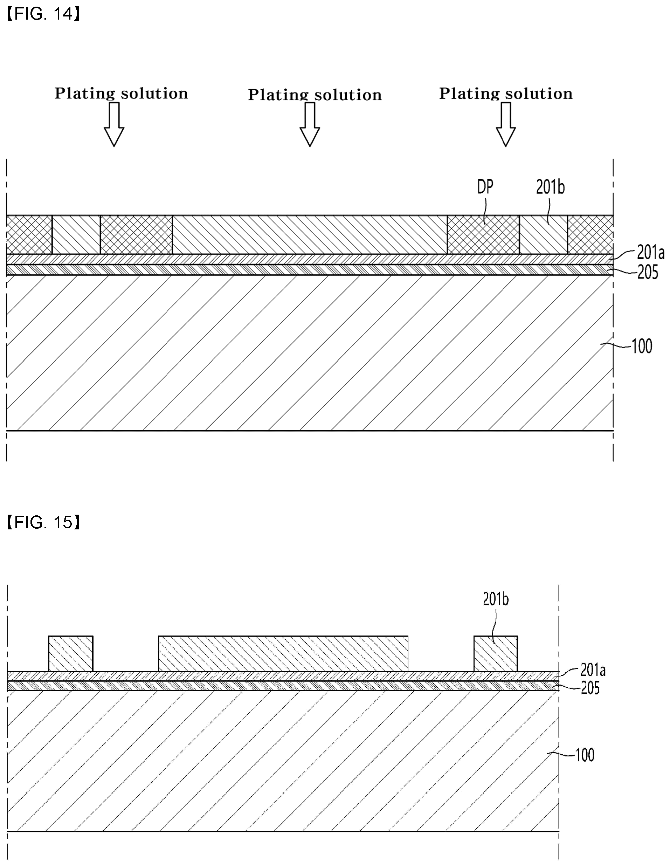

Subsequently, as shown in FIG. 14, when the plating layer on the plating region is plated to the set thickness, the plating process is finished.

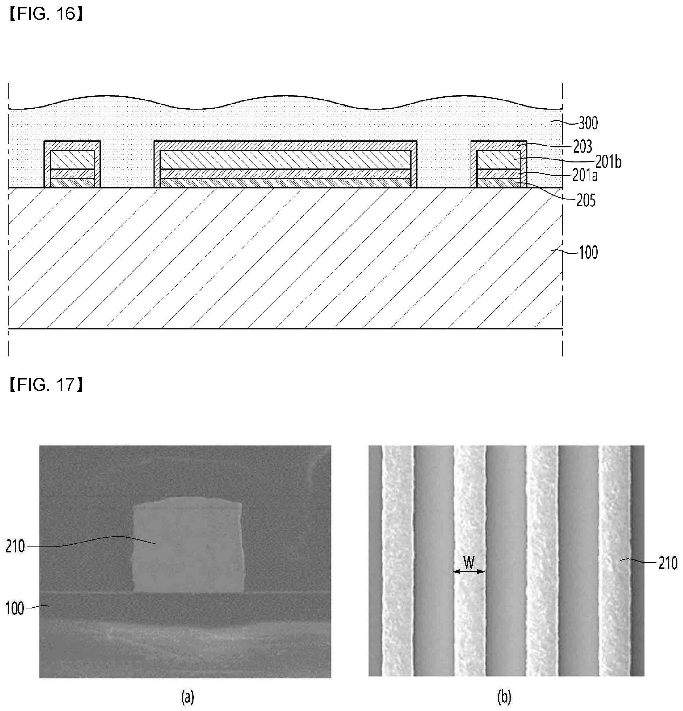

Referring to FIGS. 15 and 16, the photosensitive pattern DP is removed. Subsequently, the first metal layer 201a and the buffer layer 205 disposed under the photosensitive pattern DP are etched to separate the plurality of circuit patterns. When the first metal layer 201a and the buffer layer 205 are etched, the second metal layer 201b is etched together. Therefore, the thickness of the second metal layer 201b may be slightly reduced from a thickness after the plating process is completed. Therefore, the plating process may be performed to a thickness slightly higher than the set circuit pattern thickness.

The second process is performed to plate a second metal layer on the plating region. Accordingly, the line widths of the circuit patterns may become uniform.

As shown in FIG. 17, widths of the upper and lower portions of the circuit pattern may be similar. Accordingly, the line width W of the circuit pattern may become uniform. In addition, a line width deviation of the plurality of circuit patterns may be reduced.

In addition, the second process controls the plating thickness. In detail, a thickness deviation of the plurality of plating regions is controlled by the shielding layer 500. Accordingly, the thickness of the circuit pattern may become uniform. In addition, the thickness deviation of the plurality of circuit patterns may be reduced.

**[Table 1]**

| Measurement position | First and third pad parts | Second pad part | fourth pad part |
|---|---|---|---|
| Average thickness(um) | 12.2 | 13.4 | 13.8 |
| Thickness deviation(um) | 0.6 | 3.2 | 5.9 |
| Maximum thickness(um) | 12.5 | 15.7 | 17.9 |
| Minimum thickness(um) | 11.9 | 12.5 | 12.0 |

**[Table 2]**

| Measurement position | First and third pad parts | Second pad part | fourth pad part |
|---|---|---|---|
| Average thickness(um) | 11.8 | 12.3 | 12.0 |
| Thickness deviation(um) | 0.8 | 1.2 | 1.6 |
| Maximum thickness(um) | 12.3 | 12.9 | 12.9 |
| Minimum thickness(um) | 11.5 | 11.7 | 11.3 |

Table 1 and Table 2 are data on the thickness of the circuit pattern formed by the second process. Table 1 and Table 2 are results after the plating process is performed with the set thickness set to 12 um. Table 1 is comparative example data for plating without using the shielding layer. Table 2 is example data for plating using the shielding layer.

Referring to Table 1, an average thickness of the circuit pattern exceeds the set thickness. In addition, it can be seen that a thickness deviation of the circuit pattern is large. In particular, it can be seen that a thickness deviation of the second pad part and the fourth pad part is large. Therefore, a thickness deviation of the first pad part, the second pad part, the third pad part, and the fourth pad parts also increases.

Referring to Table 2, an average thickness of the circuit pattern is similar to the set thickness. In addition, it can be seen that a thickness deviation of the circuit pattern is small. In detail, the first pad part to the fourth pad part have a thickness deviation of 3 um or less. Accordingly, thickness deviations of the first pad part, the second pad part, the third pad part, and the fourth pad parts are also reduced.

The thickness of the circuit pattern is determined by the thickness of the second metal layer. In the embodiment, the thickness of the second metal layer is controlled by the shielding layer.

Therefore, a thickness deviation of the second metal layer of the circuit patterns is reduced. In detail, a thickness deviation of the second metal layer may be 3 um or less. In detail, a thickness deviation of the second metal layer may be 0.5 um to 3 um, 0.6 um to 2.5 um, or 0.5 um to 2 um.

In addition, a thickness deviation of the metal layer of the circuit patterns is reduced. In detail, a thickness deviation of the metal layer may be 3 um or less. In detail, a thickness deviation of the metal layer may be 0.5 um to 3 um, 0.6 um to 2.5 um, or 0.5 um to 2 um.

In addition, the thickness deviation of the circuit patterns is reduced. In detail, the thickness deviation of the circuit pattern may be 3um or less. In detail, the thickness deviation of the circuit pattern may be 0.5um to 3um, 0.6um to 2.5um, or 0.5um to 2um.

In addition, the thickness deviation of each circuit pattern is reduced.

In detail, the thickness deviation of the first circuit pattern may be 0.3um to 2.5um, 0.4um to 2um, or 0.5um to 1.5um.

In detail, the thickness deviation of the second circuit pattern may be 0.3um to 5um, 0.4um to 4um, or 0.5um to 2um.

In addition, the thickness deviation of each pad part is reduced.

In detail, the thickness deviation of each of the first pad part and the third pad part may be 0.3um to 0.9um.

In addition, the thickness deviation of the second pad part may be 0.5 um to 3 um, 0.8 um to 2 um, or 1 um to 1.5 um.

In addition, the thickness deviation of the fourth pad part may be 1 um to 5 um, 1.2 um to 3 um, or 1.5 um to 2 um.

In addition, the thickness deviation between the first circuit pattern, the second circuit pattern, and the third circuit pattern is reduced. The thickness deviation between the first circuit pattern, the second circuit pattern, and the third circuit pattern is a difference between a largest thickness and a smallest thickness of the circuit patterns. The thickness deviation between the first circuit pattern, the second circuit pattern, and the third circuit pattern may be 5 um or less. In detail, the thickness deviation between the first circuit pattern, the second circuit pattern, and the third circuit pattern may be 1 um to 5 um, 1.2 um to 4 um, or 1.4 um to 2 um.

Therefore, the flexible circuit board according to the embodiment includes circuit patterns having uniform thickness and width. In addition, the circuit pattern has a thickness exceeding 8 µm.

Therefore, the circuit pattern can be prevented from being damaged by the high current of the display panel. In addition, since the line width and thickness of the circuit patterns become uniform, the current and signal moving in each channel can become uniform. Accordingly, the electrical characteristics of the flexible circuit board and the COF module are improved.

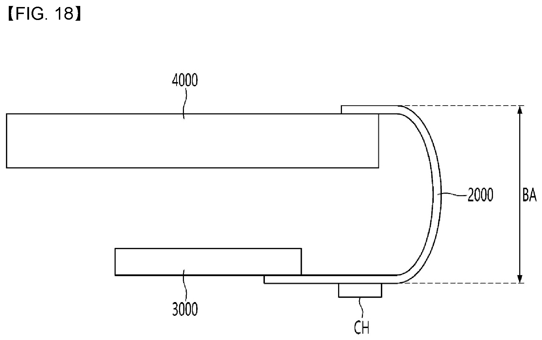

Referring to FIG. 18, one end of the COF module TP2 is connected to the display panel 4000, and other end of the COF module TP2 is connected to the circuit board 3000. For example, the display panel 4000 and the circuit board 3000 are disposed on one surface of the COF module TP2. However, the embodiment is not limited thereto. The display panel 4000 and the circuit board 3000 may be disposed on different surfaces of the COF module TP2. In this case, the COF module TP2 may have circuit patterns disposed on each of the two surfaces. For example, the COF module TP2 may include a first circuit pattern and a second circuit pattern disposed on a first surface, and a second circuit pattern and a third circuit pattern disposed on a second surface. The second circuit patterns may be connected to each other through a via.

Since the COF module TP2 includes a flexible substrate, it has a rigid shape and a bent shape between the display panel 3000 and the circuit board 4000. That is, the COF module TP2 may include a bending region BA.

The COF module TP2 connects the display panel 4000 and the circuit board 3000 that are disposed opposite each other in a bent form. Therefore, the thickness of the electronic device is reduced. In addition, the design freedom of the electronic device is improved. In addition, the COF module TP2 does not have wiring disconnected even in a bent form. Accordingly, the reliability of the electronic device is improved.

Since the COF module is flexible, it can be used in various electronic devices.

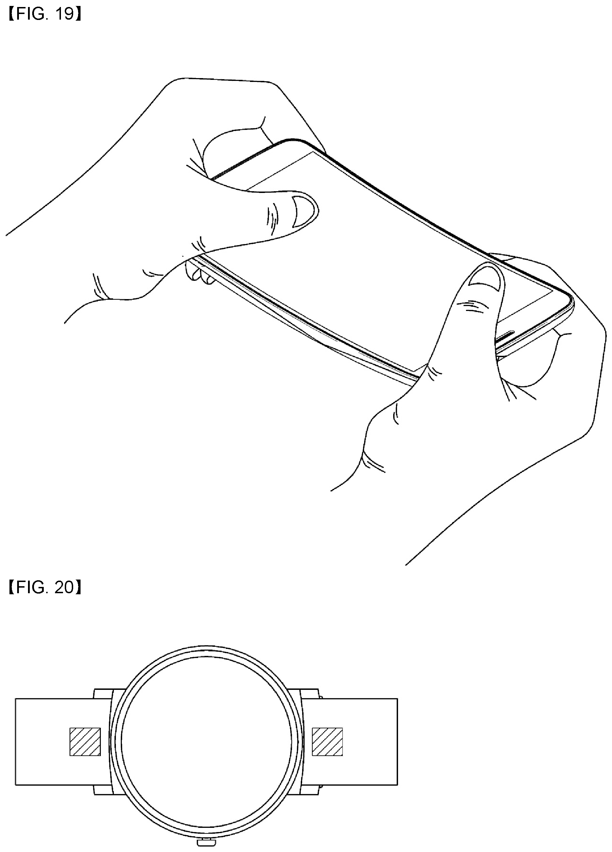

For example, referring to FIG. 19, the COF module can be applied to a flexible touch window that bends. Therefore, a touch device including it can be a flexible touch device. Therefore, a user can bend or fold the touch device by a hand. Such a flexible touch window can be applied to a wearable touch, etc.

Referring to FIG. 20, the COF module can be applied to various wearable touch devices including a curved display. Accordingly, an electronic device including the COF module can be slimmed down or made lightweight.

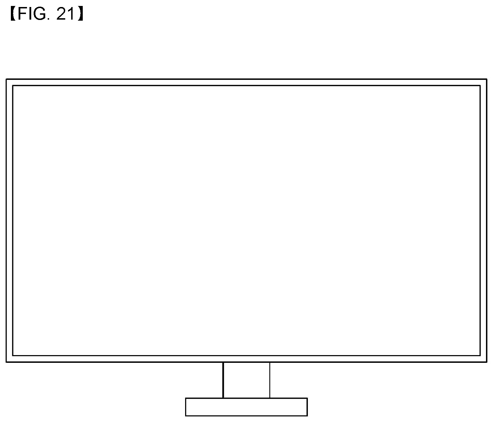

Referring to FIG. 21, the COF module can be used in various electronic devices having a display portion such as a TV, a monitor, and a laptop. At this time, the COF module can also be used in an electronic device having a curved display portion.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A flexible circuit board comprising:
a substrate;
a plurality of circuit patterns disposed on the substrate; and
a protective layer disposed on the circuit patterns,
wherein a thickness of each of the plurality of circuit patterns exceeds 8 um and is less than or equal to 25 um, and
wherein a thickness deviation between the plurality of circuit patterns is 0.5 um to 3 um.

2. The flexible circuit board of claim 1, wherein each of the plurality of circuit patterns includes:
a buffer layer disposed on the substrate,
a metal layer disposed on the buffer layer, and
a bonding layer disposed on the metal layer.

3. The flexible circuit board of claim 2, wherein the bonding layer is disposed to cover a side surface of the buffer layer, a side surface of the metal layer, and an upper surface of the metal layer.

4. The flexible circuit board of claim 2, wherein a thickness deviation between the metal layers of the plurality of circuit patterns is 0.5 um to 3 um.

5. The flexible circuit board of claim 2, wherein the metal layer includes a first metal layer and a second metal layer on the first metal layer, and
wherein a thickness of the second metal layer is greater than a thickness of the first metal layer.

6. The flexible circuit board of claim 5, wherein a thickness deviation between the second metal layers of the plurality of circuit patterns is 0.5 um to 3 um.

7. The flexible circuit board of claim 2, wherein the substrate includes a first side end and a second side end,
wherein the protective layer includes a first open region overlapping a region between the first side end and the second side end along a thickness direction, a second open region spaced apart from the first open region and most adjacent to the first side end, and a third open region spaced apart from the first open region and the second open region and most adjacent to the second side end.

8. The flexible circuit board of claim 7, wherein the plurality of the circuit pattern includes:
a first circuit pattern including a first pad part disposed in the first open region, a second pad part disposed in the second open region, and a first wiring part connecting the first pad part and the second pad part; and
a second circuit pattern including a third pad part disposed in the first open region; a fourth pad part disposed in the third open region, and a second wiring part connecting the third pad part and the fourth pad part.

9. The flexible circuit board of claim 8, wherein a thickness deviation of the first circuit pattern is 0.3 um to 2.5 um.

10. The flexible circuit board of claim 9, wherein a thickness deviation of the second circuit pattern is 0.3 um to 5 um.
